Europäisches Patentamt

European Patent Office

Office européen des brevets

(19)

(11) Veröffentlichungsnummer: **0 256 309 B1**

(12) **EUROPÄISCHE PATENTSCHRIFT**

(45) Veröffentlichungstag der Patentschrift: **21.10.92**

(51) Int. Cl.⁵: **G03F 7/26**

(21) Anmeldenummer: **87110129.1**

(22) Anmeldetag: **14.07.87**

(54) **Verfahren zur Nachbehandlung von Reliefformen.**

(30) Priorität: **25.07.86 DE 3625264**

(43) Veröffentlichungstag der Anmeldung:
**24.02.88 Patentblatt 88/08**

(45) Bekanntmachung des Hinweises auf die
Patenterteilung:
**21.10.92 Patentblatt 92/43**

(84) Benannte Vertragsstaaten:
**BE CH DE ES FR GB IT LI NL SE**

(56) Entgegenhaltungen:
**EP-A- 0 096 835**
**US-A- 3 255 004**
**US-A- 4 400 460**

**PATENT ABSTRACTS OF JAPAN, Band 7, Nr.**
**202 (P-221)[1347], 7. September 1983; & JP-**
**A-58 100 128 (TEIJIN K.K.) 14-06-1983**

(73) Patentinhaber: **BASF Aktiengesellschaft**
**Carl-Bosch-Strasse 38**
**W-6700 Ludwigshafen(DE)**

(72) Erfinder: **Bach, Helmut, Dr.**
**Dahlienstrasse 7**
**W-6704 Mutterstadt(DE)**

## Beschreibung

Die Erfindung betrifft die Verwendung von wäßrigen Lösungen von Gemischen aus Bromaten, Bromiden und Säuren zur Nachbehandlung von durch bildmäßige Photopolymerisation vernetzten Reliefformen, welche in der Reliefschicht als Bindemittel ein oder mehrere Blockcopolymerisate aus konjugierten Dienen und Vinylaromaten enthalten.

Ein solches Verfahren ist, sieht man von der erfindungsgemäßen Verbesserung ab, aus der DE-A-28 23 300 bekannt, wobei es allgemein üblich ist, hierbei Salzsäure zu verwenden.

Nachteilig für das bekannte Verfahren ist es, daß sich bei der Verwendung von Salzsäure beim Ansetzen der Nachbehandlungslösung häufig Bromnebel über der Flüssigkeitsoberfläche bilden, was sicherheitstechnische Probleme aufwirft. Außerdem können die Komponenten dieser Nachbehandlungslösung nicht vorgemischt dem Endverbraucher zugehen, sondern dieser muß sie unmittelbar vor der Anwendung selbst in den richtigen Mengenverhältnissen zusammengeben, wobei indes hierfür beim Endverbraucher, dem Reprographen, aus sicherheitstechnischen Gründen gewisse chemische Kenntnisse vorausgesetzt werden müssen, die für ihn fachfremd sind und die deshalb einer breiten Anwendung dieses Nachbehandlungsverfahres entgegenstehen. Von Nachteil ist außerdem, daß das bekannte Verfahren zwar die Klebrigkeit der Oberfläche von durch bildmäßige Photopolymerisation vernetzten Reliefformen, welche in der Reliefschicht Blockcopolymerisate aus konjugierten Dienen und Vinylaromaten als Bindemittel enthalten, effektiv beseitigt, wobei aber die hierfür notwendigen Zeiten sehr genau eingehalten werden müssen, da ansonsten die nachbehandelten Oberflächen verspröden und zur Rißbildung neigen. Selbst wenn man diese Zeiten exakt beachtet, kommt es bei den in bekannter Weise nachbehandelten Reliefformen dennoch bei längerer Lagerung und/oder bei längerem Gebrauch, z.B. als Druckformen für den Flexodruck, zum Verspröden und zur Rißbildung, was ihre Wiederverwendbarkeit, insbesondere als Druckformen, erheblich beeinträchtigt.

Die US-A 4 400 460 beschreibt ein Behandlungsverfahren für Reliefflexodruckplatten, die durch die bildweise Belichtung von Schichten gebildet werden, die als Bindemittel hochmolekulare Butadien/Acrylnitril-Copolymere mit einem zahlenmittleren Molekulargewicht von 20 000 bis 75 000, einem Acrylnitrilgehalt von 10 bis 50 Gew.-% und einem Carboxylgehalt von 0 bis 15 Gew.-% enthalten. Die entwickelte und getrocknete Oberfläche wird einer Behandlung mit aktinischer Strahlung und daran anschließend mit einer wäßrigen Bromlösung unterzogen. Hierzu werden Brom enthaltende Lösungen und ihre Herstellungsmethode zitiert, wobei in den wäßrigen Bromid/Bromat/Säure-Lösungen als Säuren z.B. HCl, HBr, Amidosulfonsäure verwendet werden.

Aus der EP-A-0 096 835 ist es bekannt, durch bildmäßige Photopolymerisation erhaltene Reliefformen aus Butadien/Acrylnitril-Copolymeren mit wäßrigen Lösungen von Gemischen aus Bromaten, Bromiden und Säuren nachzubehandeln. Als Säurekomponente sollen ausschließlich starke Protonensäuren (u.a. Amidosulfonsäure) verwendet werden.

Die US-A 4 400 460 wie auch die EP-A-0 096 835 belegen den fundamentalen Unterschied zwischen Bindemitteln, die Blockcopolymere von konjugierten Dienen und Vinylaromaten enthalten, und solchen, die Butadien/Acrylnitril-Copolymere enthalten. Diese Unterschiede beziehen sich insbesondere auf die Kompatibilität der Druckformen mit bestimmten Druckfarbenlösungsmitteln.

Die US-A 3 255 004 betrifft ein Verfahren zur Herstellung von photopolymerisierten Reliefbildern, bei dem die Oberfläche mit einer wäßrigen, 0,1- bis 2-normalen Säurelösung behandelt wird. Hierdurch sollen Nachteile wie beispielsweise die Sprödigkeit und Härte der Reliefdruckform oder die erhöhten Schwelleigenschaften in Wasser beseitigt werden. Jede Art verdünnter Säure kann in diesem Verfahren verwendet werden, sofern sie keinen nachteiligen Effekt auf das Polymer oder den Träger hat. Da bei dem in US-A 3 255 004 beschriebenen Verfahren weder Bromid noch Bromat verwendet wird, kann die Säure dort auch nicht die Funktion haben, die Bildung von elementarem Brom aus Bromid und Bromat herbeizuführen.

Aufgabe der vorliegenden Erfindung war es, das bekannte Bromat/Bromid/Salzsäure-Nachbehandlungsverfahren für durch bildmäßige Photopolymerisation vernetzte Reliefformen, welche in der Reliefschicht Blockcopolymerisate aus konjugierten Dienen und Vinylaromaten als Bindemittel enthalten, so zu verbessern, daß die vorstehend geschilderten Nachteile des Verfahrens beseitigt werden. Außerdem war es Aufgabe der Erfindung, ein Verfahren zu finden, welches nicht nur die Oberflächenklebrigkeit der Reliefformen beseitigt, sondern diese auch noch gegenüber dem Verspröden und der Rißbildung bei Langzeitlagerung und/oder Dauergebrauch stabilisiert.

Diese Aufgabe wurde überraschend gelöst durch die Verwendung wäßriger Lösungen von Gemischen aus Bromaten, Bromiden, sowie Amidosulfonsäure und/oder aliphatischen Di-, Tri- und/oder Tetracarbonsäuren zur Nachbehandlung von Reliefformen, die durch bildmäßige Photopolymerisation von Schichten hergestellt worden sind, welche als Bindemittel Blockcopolymerisate aus konjugierten Dienen und Vinylaromaten enthalten, die mindestens einen elastomeren Dien-Polymerisatblock X und mindestens einen thermoplastischen Vinylaromaten-Polymerisatblock Y enthalten.

Beispiele für geeignete erfindungsgemäß anzuwendende Bromate sind Alkali- oder Erdalkalibromate, wobei Kaliumbromat bevorzugt ist.

Beispiele für geeignete erfindungsgemäß anzuwendende Bromide sind Alkali- oder Erdalkalibromide, wobei Kaliumbromid bevorzugt ist.

Beispiele für geeignete erfindungsgemäß anzuwendende Di-, Tri- oder Tetracarbonsäuren sind Malonsäure, Bernsteinsäure, Glutarsäure, Adipinsäure, Pimelinsäure, Sebacinsäure, Azelainsäure, Tartronsäure, Äpfelsäure, Weinsäure, Itamalsäure, Citramalsäure, Cyclohexan-1,2-dicarbonsäure, Citronensäure, Methan-tetraessigsäure oder Hexan-2,3,5,6-tetracarbonsäure oder Gemische aus diesen, wobei Bernsteinsäure, Glutarsäure und/oder Adipinsäure bevorzugt sind.

Erfindungsgemäß von besonderem Vorteil ist die Verwendung von Amidosulfonsäure.

Im allgemeinen werden die Komponenten der erfindungsgemäß anzuwendenden Nachbehandlungslösung in einer solchen Menge in Wasser aufgelöst, daß sich dabei nach Gleichung 1

$$5\ Br^{\ominus} + BrO_3^{\ominus} + 6H^{\bullet} \rightarrow 3\ Br_2 + 3H_2O \qquad Gl.\ 1$$

eine 0,01 bis 10, insbesondere 0,1 bis 1 gew.%ige Lösung von Brom in Wasser bildet.

Dabei können die Komponenten einzeln oder als vorgefertigte feste Mischung in der erforderlichen Menge dem Wasser zugegeben werden.

Die Nachbehandlungslösung kann außerdem noch anionische oder kationische Tenside, welche eine gesättigte Kohlenwasserstoffkette mit 8 bis 20 Kohlenstoffatomen oder eine oder mehrere perfluorierte Kohlenstoffketten mit 5 bis 18 Kohlenstoffatomen aufweisen, und/oder Ethylenoxid/Propylenoxid-Blockcopolymerisate und/oder Alkylglucoside in einer Menge von 0,001 bis 2 Gew.% enthalten.

Methodisch bietet die erfindungsgemäße Verwendung keine Besonderheiten, d.h. man besprüht die durch bildmäßiges Belichten mit aktinischem Licht und durch Auswaschen der unbelichteten unvernetzten Anteile in bekannter Weise aus den reliefbildenden, durch Photopolymerisation vernetzbaren Schichten erhaltenen Reliefformen gegebenenfalls nach einer Trocknung und/oder einer vollflächigen Nachbelichtung mit aktinischem Licht mit der erfindungsgemäß anzuwendenden Nachbehandlungslösung oder man taucht die Reliefformen in diese Lösung ein. In beiden Fällen erweist sich eine Einwirkungszeit von 10 Sekunden bis 20 Minuten, vorzugsweise 12 Sekunden bis 15 Minuten und insbesondere 15 Sekunden bis 10 Minuten als vorteilhaft, wobei ein genaues Einhalten bestimmter Zeiten nicht erforderlich ist.

Im allgemeinen schließt sich der Nachbehandlung ein bekannter Waschschritt mit Wasser an, bei dem Bromreste von der Reliefoberfläche weggespült werden. Dabei ist es von Vorteil, wenn das Waschwasser reduzierend wirkende Stoffe wie Natriumthiosulfat oder Formaldehydnatriumsulfoxylat ($HOCH_2SO_2Na$) in einer Menge von 0,01 bis 1 Gew.% enthält. Darüber hinaus kann das Waschwasser auch noch 0,001 bis 2 Gew.% der vorstehend genannten Tenside enthalten. Üblich sind Waschzeiten von 5 bis 120, vorzugsweise 10 bis 60 und insbesondere 15 bis 40 Sekunden. Danach werden die Reliefformen getrocknet und gegebenenfalls mit aktinischem Licht vollflächig nachbelichtet.

Die erfindungsgemäße Verwendung wird an bekannten, durch Photopolymerisation vernetzten Reliefformen ausgeführt, die wie vorstehend ausgeführt, durch bildmäßiges Belichten mit aktinischem Licht und Auswaschen der unbelichteten unvernetzten Anteile der Schichten mit geeigneten Entwicklerlösungsmitteln aus reliefbildenden, durch Photopolymerisation vernetzbaren Schichten erhalten worden sind, welche Blockcopolymerisate aus konjugierten Dienen und Vinylaromaten als Bindemittel enthalten.

Beispiele geeigneter Entwicklerflüssigkeiten sind übliche und bekannte Lösungsmittel wie Perchlorethylen/n-Butanol-Gemische, Limonen, Toluol, Ethylbenzol oder N-Methylpyrrolidon oder Gemische aus diesen.

Beispiele geeigneter Lichtquellen für aktinisches Licht sind die üblichen und bekannten Quecksilberhoch-, -mittel- oder -niederdruckstrahler, UV-Fluoreszenzröhren oder Metallhalogenid - dotierte Lampen.

Als Bindemittel werden erfindungsgemäß Blockcopolymerisate aus konjugierten Dienen und Vinylaromaten verwendet, welche mindestens einen elastomeren Dien-Polymerisatblock X und mindestens einen thermoplastischen Vinylaromaten-Polymerisat-Block Y enthalten, wobei die Blöcke X und Y im allgemeinen über Kohlenstoff-Kohlenstoff-Bindungen chemisch miteinander verknüpft sind. In einem gegebenen Blockcopolymerisat kann die Verknüpfung von einem Block X mit einem Block Y auch durch ein statistisches oder ein alternierendes Copolymeres, welches konjugierte Diene und Vinylaromaten einpolymerisiert enthält, erfolgen; oder aber die Verknüpfung der Blöcke X und Y erfolgt mittels eines Copolymerisats aus konjugierten Dienen und Vinylaromaten, in welchem die Konzentration einpolymerisierter konjugierter Diene vom Block X zum Block Y hin ab- und die Konzentration einpolymerisierter Vinylaromaten zunimmt.

Darüber hinaus können solche Blockcopolymerisate über geeignete mehrbindige Atome oder Ionen sowie anorganische, organische oder metallorganische Molekülreste zu noch größeren Blockcopolymerisat-Verbänden verknüpft werden. Dabei ist unter Verknüpfung die Bildung kovalenter oder ionischer Bindungen zwischen zwei Molekülresten zu verstehen.

Außerdem können die olefinischen und aromatischen Bindungen oder auch nur die olefinischen Bindungen in den Dienpolymerisat-Blöcken X partiell oder vollständig hydriert vorliegen. Zudem können die Blöcke X und Y weitere Monomere, bei welchen es sich nicht um konjugierte Diene und Vinylaromaten handeln muß, einpolymerisiert enthalten, wie beispielsweise Acrylnitril, Acrylsäure, Maleinsäureanhydrid, (Meth)Acrylsäureamide oder (Meth)acrylsäureester, wobei deren Anteil am Blockcopolymerisat im allgemeinen 10 Gew.% nicht übersteigen soll. Dabei können die Blöcke X auch Vinylaromaten einpolymerisiert enthalten, wobei deren Menge so gewählt wird, daß sie die elastomeren Eigenschaften der Blöcke X nicht beeinträchtigt. Ebenso können die Blöcke Y so viele konjugierte Diene einpolymerisiert enthalten, daß ihre thermoplastische Verarbeitbarkeit nicht verloren geht.

Enthält ein Blockcopolymerisat mehrere elastomere Blöcke X und/oder thermoplastische Blöcke Y, dann müssen die Blöcke X bzw. Y nicht jeweils chemisch identisch oder angenähert gleich sein, sondern sie können sich jeweils deutlich voneinander unterscheiden, sofern sie stets die erforderlichen elastomeren bzw. thermoplastischen Eigenschaften aufweisen.

Im allgemeinen weisen Blöcke X eine Glastemperatur Tg von unterhalb 20°C, vorzugsweise unterhalb 0°C und insbesondere unterhalb -15°C auf. Diese Blöcke können im allgemeinen eine mittlere Molmasse von $10^3$ bis $2 \cdot 10^5$ aufweisen. Im allgemeinen enthalten sie 30 bis 100, insbesondere 30 bis 95 Gew.%, bezogen auf den jeweiligen Block X, an einpolymerisierten konjugierten Dienen.

Blöcke Y weisen im allgemeinen eine Glastemperatur Tg von mehr als 20°C auf. Sie haben im allgemeinen eine mittlere Molmasse von $1,5 \cdot 10^3$ bis $2 \cdot 10^6$, vorzugsweise $5 \cdot 10^3$ bis $1,5 \cdot 10^6$ und insbesondere $10^4$ bis $1,2 \cdot 10^6$. Sie enthalten im allgemeinen 30 bis 100, insbesondere 40 bis 90 Gew.%, bezogen auf den jeweiligen Block Y, an einpolymerisierten Vinylaromaten.

Beispiele für geeignete konjugierte Diene sind Butadien, Isopren, Pentan-1,3-dien, 2,3-Dimethylbutadien oder Hexan-2,4-dien, wobei Butadien und/oder Isopren bevorzugt sind.

Beispiele für geeignete Vinylaromaten sind Styrol, α-Methylstyrol, p-Methylstyrol, p-tert.-Butylstyrol oder 1-Vinylnaphthalin, wobei Styrol bevorzugt ist.

Als Beispiele für besonders gut geeignete Blockcopolymerisate seien thermoplastisch elastomere Dreiblockcopolymerisate Y-X-X' angeführt, in denen Y einen thermoplastischen, nicht elastischen Styrolpolymerisat-Block, X einen elastomeren Butadien- und/oder Isoprenpolymerisat-Block und X' einen von X verschiedenen elastomeren Polymerisat-Block aus einpolymerisiertem Butadien und/oder Isopren sowie gegebenenfalls einpolymerisiertem Styrol darstellt.

Im allgemeinen enthalten die reliefbildenden, durch Photopolymerisation vernetzbaren Schichten diese Blockcopolymerisate in einer Menge von 40 bis 99, vorzugsweise 60 bis 98 und insbesondere 70 bis 95 Gew.% bezogen auf die jeweilige Schicht, als Bindemittel.

Bekanntermaßen enthalten diese reliefbildenden Schichten außer den vorstehend genannten Blockcopolymerisaten stets auch noch hiermit verträgliche photopolymerisierbare Monomere sowie die zur Initiierung der Photopolymerisation notwendigen Photoinitiatoren. Darüber hinaus können die Schichten weitere Zusatzstoffe wie etwa Inhibitoren der thermisch initiierten Polymerisation, Farbstoffe, Pigmente, photochrome Stoffe, Lichthofschutzmittel, Weichmacher, Antioxidantien, Antiozonantien, Mittel zur Verbesserung der Reliefstruktur, Vernetzungshilfsmittel, Füllmittel und/oder Verstärkerfüllstoffe in wirksamen Mengen enthalten.

Die Herstellung solcher Schichten aus ihren Komponenten erfolgt im allgemeinen durch Mischen der Komponenten mit Hilfe bekannter Mischmethoden und durch Verarbeiten der Mischungen zu Schichten mit Hilfe bekannter Techniken wie Gießen aus Lösung, Kalandrieren oder Extrudieren, wobei diese Maßnahmen auch in geeigneter Weise miteinander kombiniert werden können.

Die Schichten können als solche in bekannter Weise zu Reliefformen verarbeitet und anschließend in erfindungsgemäßer Verfahrensweise nachbehandelt werden. Sie können aber auch bekanntermaßen im Verbund mit weiteren geeigneten schichtförmigen Materialien zu Reliefformen verarbeitet und dann nachbehandelt werden. Üblicherweise bezeichnet man solche Verbunde als "Mehrschichtenelemente".

Die nach den bekannten Methoden hergestellten und in erfindungsgemäßer Weise nachbehandelten Reliefformen können als dekorative Oberflächen, als Druckformen für den Flach-, Hoch- und Flexodruck sowie als Photoresists verwendet werden. Vorzugsweise werden sie als Druckformen für den Flexodruck, insbesondere beim Endlosdruck, verwendet.

Die erfindungsgemäße Verwendung wäßriger Lösungen von Gemischen aus Bromaten, Bromiden, sowie Amidosulfonsäure und/oder aliphatischen Di-, Tri- und Tetracarbonsäuren in Nachbehandlungsverfahren weist gegenüber dem Stand der Technik zahlreiche Vorteile auf. So können die wirksamen Komponenten der Nachbehandlungslösung, die Bromate, Bromide und Säuren, dem Reprographen als fertige, leicht dosierbare, im trockenen Zustand unbegrenzt lagerfähige Mischung geliefert werden, die er nur noch in Wasser aufzulösen braucht, wobei hierfür auf umfangreiche technische Sicherheitsmaßnahmen verzichtet werden kann und keine besonderen chemischen Kenntnisse erforderlich sind. Außerdem müssen die durch Vorversuche ermittelten optimalen Nachbehandlungszeiten nicht streng eingehalten werden, um Schädigungen der Oberfläche der Reliefformen zu vermeiden, sondern sie können, wenn der betriebliche Ablauf dies erfordert, ohne weiteres überschritten werden, was der Koordination von Arbeitsgängen in einem reprographischen Betrieb erheblich mehr Spielraum läßt. Ein zusätzlicher Vorteil ist, daß die erfindungsgemäß anzuwendenden Nachbehandlungslösungen länger haltbar sind und selbst nach längerer Standzeit und/oder mehrmaligem Gebrauch durch weitere Zugabe von erfindungsgemäß anzuwendenden Bromat/Bromid/Säure-Gemischen regeneriert werden können, ohne daß dies zu nachteiligen Ergebnissen führt. Außerdem wirken sie weniger korrosiv als bekannte Nachbehandlungslösungen. Darüber hinaus verbessert die erfindungsgemäße Verwendung wäßriger Lösungen von Gemischen aus Bromaten, Bromiden, sowie Amidosulfonsäure und/oder aliphatischen Di-, Tri- und Tetracarbonsäuren in Nachbehandlungsverfahren die Oberfläche der Reliefformen nicht nur hinsichtlich der Klebrigkeit, des Gleichmaßes der Mattheit und der optischen Homogenität, sondern es stabilisiert sie zugleich gegen die Versprödung und die Rißbildung bei längerer Lagerung und/oder Dauergebrauch. Daher sind solche Reliefformen erheblich öfter und länger im Flexodruck verwendbar als nach Verfahren des Standes der Technik nachbehandelte. Erfindungsgemäß nachbehandelte Reliefformen liefern demnach auch eine sehr viel höhere Auflage an ausgezeichneten Drucken. Hinzu kommt noch, daß diese Reliefformen eine vorzügliche Farbannahme aufweisen, dabei aber gegenüber den Druckfarbenlösungsmitteln ausgesprochen stabil sind und von diesen nicht in einem störenden Ausmaß angequollen werden.

## Beispiele und Vergleichsversuche

In den folgenden Beispielen und Vergleichsversuchen wurde die Klebrigkeit der Oberflächen der Reliefformen mit Hilfe des Tastsinns bestimmt und wie folgt benotet:

Note 1 - nicht klebrig;

Note 2 - schwach klebrig;

Note 3 - stark klebrig.

Das Gleichmaß der Mattheit und der Grad der optischen Homogenität der Oberflächen wurden mit Hilfe rasterelektronenmikroskopischer Aufnahmen bestimmt und wie folgt beurteilt:

Note 1 - gleichmäßig matte, strukturlose Oberfläche;

Note 2 - gleichmäßig matte, leicht strukturierte Oberfläche;

Note 3 - ungleichmäßig matte, strukturierte Oberfläche;

Note 4 - inhomogene, rauhe Oberfläche.

Für die Beispiele und Vergleichsversuche wurden zunächst handelsübliche Flexodruckplatten (Mehrschichtenelemente) mit einer bekannten reliefbildenden, durch Photopolymerisation vernetzbaren Schicht in üblicher Weise hergestellt. Dabei dienten als Trägerfolien 125 $\mu$m dicke Polyethylenterephthalatfolien, die vor dem Aufbringen der Schichten mit 0,3 $\mu$m dicken Polyurethan-Haftlackschichten beschichtet worden waren. Die reliefbildenden Schichten selbst wiesen eine Dicke von 700 $\mu$m auf und enthielten, bezogen auf eine Schicht,

als Bindemittel:

90,917 Gew.%

eines Blockcopolymerisats Y-X-X' mit einer Viskositätszahl VZ von 164,9 ml/g, einer mittleren Molmasse von $1,9 \cdot 10^5$ und einer Zusammensetzung aus, bezogen auf das Blockcopolymerisat,

10 Gew.% Polystyrol als Y-Block,

70 Gew.% Polyisopren (Glastemperatur Tg: -35°C) als X-Block

und

20 Gew.% Polyisopren mit einem Gehalt von 53 % an 3,4-Strukturen (Glastemperatur Tg: +10°C) als X'-Block;

als photopolymerisierbares Monomeres:

7,268 Gew.% Hexan-1,6-dioldiacrylat;

als Photoinitiator:

1,350 Gew.% Benzildimethylacetal;

und als Zusatzstoffe:

0,457 Gew.% 2,6-Di-tert.-butyl-p-kresol und

0,008 Gew.% Solvent Black 3 (C.I. 26150).

Als Schutzschichten wurden 2 $\mu$m dicke Schichten aus Cyclokautschuk hohen Cyclisierungsgrades verwendet.

Diese Flexodruckplatten wurden zunächst während 2 Minuten von ihrer Rückseite her in einem Röhrenbelichter vollflächig vorbelichtet, anschließend durch eine der Schutzschicht aufliegenden Negativvorlage hindurch während 22 Minuten bildmäßig belichtet und dann bei 30°C in einem Reibewascher mit einem Perchlorethylen/n-Butanol-Gemisch entwickelt, wobei man die unbelichteten, nicht vernetzten Anteile der Flexodruckplatten entfernte.

Die so erhaltenen Reliefformen wurden während 2 Stunden bei 65°C getrocknet und während 15 Stunden bei Raumtemperatur gelagert. Anschließend wurden die Reliefformen unterschiedlichen Nachbehandlungen unterworfen.

## Beispiele 1 bis 3

Erfindungsgemäße Nachbehandlung von Reliefformen; Versuchsvorschrift:
Eine Nachbehandlungslösung wurde aus 507,54 g KBr, 142,46 g KBrO$_3$, 1000 g Amidosulfonsäure und 100 l Wasser hergestellt und für die Beispiele 1 bis 3 verwendet.

## Beispiel 1

Unmittelbar nach ihrer Herstellung wurden zwei Relieffformen in die Nachbehandlungslösung eingetaucht und 5 Minuten darin belassen.

## Beispiel 2

Gleichzeitig mit den Relieffformen aus Beispiel 1 wurden zwei weitere in die Lösung eingetaucht und 1 Stunde darin belassen.

## Beispiel 3

Nach 1 Woche Standzeit der Nachbehandlungslösung wurden wiederum zwei Relieffformen in die Lösung eingetaucht und 5 Minuten darin belassen.

Alle sechs Relieffformen wurden nach ihrer Entnahme aus der Nachbehandlungslösung in eine Lösung aus 1 Gew.% Natriumthiosulfat, 1 Gew.% eines Natriumparaffinsulfonates und 98 Gew.% Wasser eingetaucht und 30 Sekunden darin belassen. Danach wurden die Relieffformen getrocknet und mit aktinischem Licht vollflächig nachbelichtet.

Alle sechs Relieffformen wiesen eine nichtklebrige (Note 1), gleichmäßig matte, strukturlose (Note 1) Oberfläche auf. Jeweils eine von zwei in gleicher Weise nachbehandelten Relieffformen wurde 3 Monate lang an der Luft gelagert. Selbst nach dieser Zeit versprödete ihre Oberfläche nicht und wies auch keine Risse auf. Die übrigen Relieffformen wurden auf Druckzylinder für den Endlosdruck in einem Flexodruckwerk aufgespannt und lieferten selbst bei einer Auflage von bis zu 10$^6$ Druckexemplaren noch ausgezeichnete Ergebnisse. Die Druckzylinder konnten mehrmals in dieser Weise verwendet werden, ohne daß es zu Informationsverlusten gegenüber der ursprünglichen Negativvorlage kam.

## Vergleichsversuche A bis C

Nachbehandlung von Relieffformen nach dem Verfahren des Standes der Technik; Versuchsvorschrift:

Es wurde eine Nachbehandlungslösung aus 507,54 g KBr, 142,46 g KBrO$_3$, 1000 ml konzentrierter Salzsäure und 100 l Wasser hergestellt und für die Vergleichsversuch A bis C verwendet.

## Vergleichsversuch A

Beispiel 1 wurde unter Verwendung der bekannten Nachbehandlungslösung wiederholt

## Vergleichsversuch B

Beispiel 2 wurde ebenfalls unter Verwendung dieser Lösung wiederholt.

## Vergleichsversuch C

Ebenso wurde Beispiel 3 unter Verwendung dieser Lösung wiederholt.

Die weitere Behandlung der sechs Relieffformen erfolgte wie bei den Beispielen 1 bis 3 angegeben.

Alle drei Relieffformpaare wiesen zwar eine nichtklebrige (Note 1) Oberfläche auf, sie unterschieden sich jedoch in den übrigen Eigenschaften deutlich voneinander und von den in erfindungsgemäßer Weise nachbehandelten Paaren:
Die nach dem Vergleichsversuch A erhaltenen Relieffformen wiesen zwar eine gleichmäßig matte, leicht strukturierte (Note 2) Oberfläche auf, die jedoch nach 3 monatiger Lagerung versprödete und riß. Druckversuche ergaben, daß sie den Qualitätsanforderungen, welche an eine Druckform für den Endlosdruck gestellt werden, nicht genügten.

Die nach Vergleichsversuch B erhaltenen Relieffformen wiesen eine inhomogene rauhe (Note 4) Oberfläche auf, die rasch versprödete und riß. Die Relieffformen konnten nicht als Druckformen verwendet werden.

Die nach Vergleichsversuch C erhaltenen Relieffformen wiesen eine ungleichmäßig matte, strukturierte (Note 3) Oberfläche auf, die rasch versprödete und riß. Die Relieffformen lieferten als Druckformen Kopien minderer Qualität und konnten nur einmal zum Druck verwendet werden.

## Beispiel 4

Erfindungsgemäße Nachbehandlung einer Relieffform; Versuchsvorschrift:
Es wurde eine Nachbehandlungslösung, wie bei den Beispielen 1 bis 3 angegeben, hergestellt, nur daß anstelle der Amidosulfonsäure ein Gemisch aus, bezogen auf das Gemisch, 29 Gew.% Adipinsäure, 44 Gew.% Glutarsäure und 27 Gew.% Bernsteinsäure verwendet wurde. Zusätzlich wurden dieser Lösung noch 200 g eines Natriumparaffinsulfonates zugesetzt.

In diese Lösung wurden zwei Reliefformen 10 Minuten lang eingetaucht und, wie bei Beispiel 1 bis 3 angegeben, weiterbehandelt.

Die Oberfläche der Reliefformen war danach nicht-klebrig (Note 1) sowie gleichmäßig matt und strukturlos (Note 1). Eine der beiden Reliefformen wurde 3 Monate lang gelagert, ohne daß es zu einer Versprödung oder Rißbildung kam. Die andere Reliefform wurde, wie bei den Beispielen 1 bis 3 angegeben, zu Druckzwecken verwendet und lieferte wiederholt ausgezeichnete Kopien in einer Auflage von jeweils $10^6$ Stück. Selbst nach dieser mehrfachen Beanspruchung kam es bei der weiteren Lagerung des Druckzylinders zu keiner Versprödung oder Rißbildung.

**Patentansprüche**

1.  Verwendung wäßriger Lösungen von Gemischen aus Bromaten, Bromiden, sowie Amidosulfonsäure und/oder aliphatischen Di-, Tri- und/oder Tetracarbonsäuren zur Nachbehandlung von Reliefformen, die durch bildmäßige Photopolymerisation von Schichten hergestellt worden sind, welche als Bindemittel Blockcopolymerisate aus konjugierten Dienen und Vinylaromaten enthalten, die mindestens einen elastomeren Dien-Polymerisatblock X und mindestens einen thermoplastischen Vinylaromaten-Polymerisatblock Y enthalten.

**Claims**

1.  Use of an aqueous solution of a mixture of bromates, bromides and amidosulfuric acid and/or aliphatic di-, tri- and/or tetracarboxylic acids for the aftertreatment of relief plates which have been produced by imagewise photopolymerization of layers which contain, as binders, block copolymers of conjugated dienes and vinylaromatics, which contain at least one elastomeric diene polymer block X and at least one thermoplastic vinylaromatic polymer block Y.

**Revendications**

1.  Utilisation de solutions aqueuses de mélanges de bromates, de bromures ainsi que d'acides amidosulfoniques et/ou d'acides aliphatiques di-, tri- et/ou tétracarboxyliques pour le traitement ultérieur de formes en relief, qui ont été fabriquées par photopolymérisation, selon une image, de couches qui contiennent comme liants des copolymérisats en blocs de diènes et d'aromates vinyliques conjugués, qui contiennent au moins un bloc de polymérisat de diène élastomère X et au moins un bloc de polymérisat d'aromates vinyliques thermoplastique Y.